(19) Europäisches Patentamt / European Patent Office / Office européen des brevets

(11) **EP 4 205 259 B1**

(12) **EUROPÄISCHE PATENTSCHRIFT**

(45) Veröffentlichungstag und Bekanntmachung des Hinweises auf die Patenterteilung:
**09.10.2024 Patentblatt 2024/41**

(21) Anmeldenummer: **21766176.8**

(22) Anmeldetag: **26.08.2021**

(51) Internationale Patentklassifikation (IPC):
**H03K 17/691** *(2006.01)*    **H02J 50/12** *(2016.01)*
**H02J 50/40** *(2016.01)*

(52) Gemeinsame Patentklassifikation (CPC):
**H03K 17/691; H02J 50/12; H02J 50/402;**
H03K 2217/009; Y02T 10/70; Y02T 10/7072;
Y02T 90/14

(86) Internationale Anmeldenummer:
**PCT/EP2021/073568**

(87) Internationale Veröffentlichungsnummer:
**WO 2022/043413 (03.03.2022 Gazette 2022/09)**

(54) **SENDEVORRICHTUNG UND ENERGIEÜBERTRAGUNGSSYSTEM ZUM KONTAKTLOSEN ÜBERTRAGEN VON ELEKTRISCHER ENERGIE MITTELS INDUKTIVER KOPPLUNG ODER MITTELS KAPAZITIVER KOPPLUNG**

TRANSMITTER DEVICE AND ENERGY TRANSFER SYSTEM FOR CONTACTLESSLY TRANSFERRING ELECTRICAL ENERGY BY MEANS OF INDUCTIVE COUPLING OR BY MEANS OF CAPACITIVE COUPLING

DISPOSITIF ÉMETTEUR ET SYSTÈME DE TRANSMISSION D'ÉNERGIE POUR ASSURER LA TRANSMISSION SANS CONTACT D'ÉNERGIE ÉLECTRIQUE PAR COUPLAGE INDUCTIF OU PAR COUPLAGE CAPACITIF

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **28.08.2020 DE 102020210894**

(43) Veröffentlichungstag der Anmeldung:
**05.07.2023 Patentblatt 2023/27**

(73) Patentinhaber: **Fraunhofer-Gesellschaft zur Förderung
der angewandten Forschung e.V.
80686 München (DE)**

(72) Erfinder:
 • **BÜKER, Maik-Julian
  09126 Chemnitz (DE)**
 • **WITTEMEIER, Steffen
  33613 Bielefeld (DE)**

(74) Vertreter: **Schenk, Markus
Schoppe, Zimmermann, Stöckeler
Zinkler, Schenk & Partner mbB
Patentanwälte
Radlkoferstrasse 2
81373 München (DE)**

(56) Entgegenhaltungen:
 CN-A- 110 620 446    US-A1- 2014 184 150
 US-A1- 2015 008 753    US-A1- 2015 236 526
 US-A1- 2018 323 637    US-A1- 2020 200 937

 • LI SIQI ET AL: "Wireless Power Transfer for Electric Vehicle Applications", IEEE JOURNAL OF EMERGING AND SELECTED TOPICS IN POWER ELECTRONICS, IEEE, PISCATAWAY, NJ, USA, vol. 3, no. 1, 1 March 2015 (2015-03-01), pages 4 - 17, XP011571726, ISSN: 2168-6777, [retrieved on 20150129], DOI: 10.1109/JESTPE.2014.2319453

**Beschreibung**

Die Erfindung betrifft Energieübertragungssysteme zum kontaktlosen Übertragung von elektrischer Energie mittels induktiver Kopplung oder mittels kapazitiver Kopplung und insbesondere eine Sendevorrichtung für ein derartiges Energieübertragungssystem.

Kontaktlose elektrische Energieübertragungssysteme sind aus den Referenzen [1] bis [17] bekannt.

Die Referenzen [18] bis [20] offenbaren jeweils Steuerverfahren für drahtlose Ladesysteme.

Die Aufgabe der vorliegenden Erfindung besteht darin, derartige Energieübertragungssysteme zu verbessern.

Die Aufgabe wird gelöst durch ein Energieübertragungssystem gemäß Anspruch 1.

Durch die Verwendung einer induktiven Kopplung, bei der die Energie im Wesentlichen über ein elektrisches (Nah-)Feld übertragen wird, oder durch die Verwendung einer kapazitiven Kopplung, bei der die Energie im Wesentlichen über ein magnetisches (Nah-)Feld übertragen wird, kann ein höherer Wirkungsgrad erreicht werden, als bei der Verwendung einer Strahlungskopplung, bei der die Energie im Wesentlichen über ein elektromagnetisches (Fern-)Feld übertragen wird.

Bei der elektrischen Wechselgröße kann es sich um einen Wechselstrom oder um eine Wechselspannung handeln. Dementsprechend kann es sich bei der Energiequelle um eine Wechselstromquelle oder um eine Wechselspannungsquelle handeln. Bevorzugt weisen die elektrischen Wechselgrößen der verschiedenen Sendemodule dieselbe Winkelfrequenz auf.

Bei der Steuereinrichtung kann es sich insbesondere um eine elektronische Steuereinrichtung handeln. Sie kann in Hardware ausgeführt sein oder in einer Kombination von Hardware und Software.

Ein Kopplungsfaktor entspricht dabei dem Imaginärteil der Streuimpedanz zwischen einem der Feldempfangselemente und einem der Felderzeugungselemente geteilt durch die Winkelgeschwindigkeit. Dabei ist die Streuimpedanz im Falle der induktiven Kopplung die Streuinduktivität und im Falle der kapazitiven Kopplung die Streukapazität zwischen einem der Feldempfangselemente und einem der Felderzeugungselemente. Werden die Kopplungsfaktoren matrizenartig angeordnet, so entsteht hierdurch die Kopplungsmatrix.

Sofern lediglich ein Empfangsmodul vorgesehen ist, wird die Kopplungsmatrix eindimensional. Unter der Annahme, dass die Sendemodule baugleich sind, bzw. dieselben elektrischen Eigenschaften aufweisen, ist die optimale Verteilung der Ströme in den Sendemodulen dann proportional zu den Werten der eindimensionalen Kopplungsmatrix. Die Werte der Ströme ergeben sich dann aus der geforderten Leistung.

Auf diese Weise kann ein höherer elektrischer Wirkungsgrad erreicht werden, als dies bei Sendevorrichtungen der Fall ist, bei denen, wie in [1] beschrieben, während der Übertragung der elektrischen Energie lediglich eine von mehreren Sendemodulen genutzt ist. Auch kann so ein höherer elektrischer Wirkungsgrad erreicht werden, als dies bei Sendevorrichtungen der Fall ist, bei denen, wie in [3] beschrieben, Metamaterialien verwendet werden. Darüber hinaus kann so ein höherer elektrischer Wirkungsgrad erreicht werden, als dies bei Sendevorrichtungen der Fall ist, bei denen, wie in [9] beschrieben, eine durch Interferenzen bewirkte Strahlformung vorgenommen wird, was sowieso nur möglich ist, wenn die Wellenlänge des Wechselenergiefeldes klein gegenüber dem Abstand zwischen der Sendevorrichtung und den Empfangsmodulen ist.

Gemäß der Erfindung weist das Energieübertragungssystem mehrere Empfangsmodule auf, wobei wenigstens eines der Empfangsmodule ein parallel zum Feldempfangselement geschaltetes einstellbares Kompensationselement aufweist, wobei das jeweilige Empfangsmodul zur Einstellung des jeweiligen Kompensationselements in Abhängigkeit von einer Kreuzkopplungsmatrix ausgebildet ist, wobei die Kreuzkopplungsmatrix für mehrere oder für alle der Feldempfangselemente Kreuzkopplungsfaktoren zu mehreren oder zu allen der anderen Feldempfangselemente umfasst.

Bei den Kompensationselementen kann es sich um Spulen oder Kapazitäten handeln. Auf diese Weise kann der elektrische Wirkungsgrad weiter verbessert werden, da so Kreuzstreuimpedanzen kompensiert werden können.

Gemäß einer vorteilhaften Weiterbildung der Erfindung ist die Steuereinrichtung zum derartigen Ansteuern der elektrischen Energiequellen ausgebildet ist, dass in dem Energieübertragungsmodus die elektrischen Wechselgrößen in Abhängigkeit von einer Singulärwertzerlegung einer von einer Kopplungsmatrix abhängigen Matrix gesteuert sind ausgebildet.

Aus der Kopplungsmatrix kann unter Berücksichtigung der Verluste in den Sendemodulen, der Verluste in den Empfangsmodulen und der Lastwiderstände eine von der Kopplungsmatrix abhängige Matrix erzeugt werden, deren Singulärwertzerlegung dazu genutzt werden kann, die elektrischen Wechselgrößen der einzelnen Sendemodule gleichzeitig so zu steuern, dass der elektrische Wirkungsgrad der Energieübertragung optimiert werden kann. Eine Singulärwertzerlegung (Abk.: SWZ oder SVD für Singular Value Decomposition) einer Matrix bezeichnet deren Darstellung als Produkt dreier spezieller Matrizen. Hierdurch kann für eine beliebige Anzahl von Empfangsmodulen der elektrische Wirkungsgrad optimiert werden, selbst wenn die Sendemodule unterschiedliche elektrische Eigenschaften aufweisen.

Gemäß einer zweckmäßigen Weiterbildung der Erfindung ist die Steuereinrichtung für jedes der Sendemodule zur Steuerung einer Amplitude der jeweiligen elektrischen Wechselgröße ausgebildet. Nach einer vorteilhaften Weiterbildung der Erfindung ist die Steuereinrichtung für jedes der Sendemodule zur Steuerung einer Phase der jeweiligen elektrischen Wechselgröße ausgebildet. Durch die oben beschriebene Steuerung der Amplituden und/oder der Phasen der Wechselgrößen der einzelnen Sendemodule ergibt sich ein besonders hoher elektrischer Wirkungsgrad.

Nach einer vorteilhaften Weiterbildung der Erfindung sind die Felderzeugungselemente Spulen, welche jeweils das jeweilige Wechselenergiefeld in Form eines magnetischen Wechselfeldes erzeugen. Auf diese Weise kann die elektrische Energie induktiv gekoppelt übertragen werden, sofern die Feldempfangselemente der Empfangsmodule ebenfalls Spulen sind. Die Kopplungsfaktoren entsprechen dabei dem Imaginäranteil der Streuinduktivitäten zwischen den Spulen der Sendevorrichtung und jeweils einer Spule eines der Empfangsmodule geteilt durch die Winkelfrequenz der zugehörigen Wechselgröße bzw. des zugehörigen Wechselenergiefeldes.

Gemäß einer bevorzugten Weiterbildung der Erfindung sind die Felderzeugungselemente Kapazitäten, welche jeweils das jeweilige Wechselenergiefeld in Form eines elektrischen Wechselfeldes erzeugen. Auf diese Weise kann die elektrische Energie kapazitiv gekoppelt übertragen werden, sofern die Feldempfangselemente der Empfangsmodule ebenfalls Kapazitäten sind. Die Kopplungsfaktoren entsprechen dabei dem Imaginäranteil der Streukapazitäten zwischen den Kapazitäten der Sendevorrichtung und jeweils einer Kapazität eines der Empfangsmodule geteilt durch die Winkelfrequenz der zugehörigen Wechselgröße bzw. des zugehörigen Wechselenergiefeldes.

Nach einer vorteilhaften Weiterbildung der Erfindung ist in dem Energieübertragungsmodus die von der Kopplungsmatrix abhängige Matrix abhängig von einer Kreuzkopplungsmatrix ist, wobei die Kreuzkopplungsmatrix für mehrere oder für alle der Feldempfangselemente Kreuzkopplungsfaktoren zu mehreren oder zu allen der anderen Feldempfangselemente umfasst. Hierdurch kann der elektrische Wirkungsgrad der Energieübertragung weiter erhöht werden, insbesondere wenn die Kreuzkopplungsfaktoren im Verhältnis zu den Kopplungsfaktoren groß sind. Ein Kreuzkopplungsfaktor entspricht dabei dem Imaginäranteil der Kreuzstreuimpedanz zwischen einem der Feldempfangselemente und einem der anderen Feldempfangselemente geteilt durch die Winkelgeschwindigkeit. Werden die Kreuzkopplungsfaktoren matrizenartig angeordnet, so entsteht hierdurch die Kreuzkopplungsmatrix. Sofern die Feldempfangselemente Spulen sind, entsprechen die Kreuzkopplungsfaktoren der Kreuzstreuinduktivität zwischen einer Spule der Empfangsmodule und einer anderen Spule der Empfangsmodule geteilt durch die Winkelfrequenz des Wechselenergiefeldes. Sofern die Feldempfangselemente Kapazitäten sind, entsprechen die Kreuzkopplungsfaktoren der Kreuzstreuinduktivität zwischen einer Kapazität der der Empfangsmodule und einer anderen Kapazität der Empfangsmodule geteilt durch die Winkelfrequenz des Wechselenergiefeldes.

Gemäß einer zweckmäßigen Weiterbildung der Erfindung ist zumindest ein Teil der Kopplungsfaktoren in der Steuereinrichtung hinterlegt. Diese Lösung ist besonders geeignet, wenn die geometrische Anordnung der Empfangsmodule in Bezug auf die Sendevorrichtung während der Energieübertragung zumindest ungefähr bekannt und gleichbleibend ist. In diesem Fall können die Kopplungsfaktoren vorab mittels geeigneter Simulationen ermittelt und in der Steuereinrichtung abgespeichert werden.

Nach einer vorteilhaften Weiterbildung der Erfindung ist die Steuereinrichtung in einem Ermittlungsmodus zur Ermittlung wenigstens eines Teils der Kopplungsfaktoren ausgebildet, wobei die Steuereinrichtung im Ermittlungsmodus zur sequentiellen Durchführung von Ermittlungssequenzen für mehrere oder für alle der Sendemodule ausgebildet ist, wobei bei jeder der Ermittlungssequenzen durch die Steuereinrichtung ausschließlich die elektrische Energiequelle des jeweiligen Sendemoduls angesteuert ist und durch die Steuereinrichtung von mehreren oder von allen der Feldempfangselemente eine empfangsqualitätskennzeichnende Größe empfangen ist, um aus jeder der empfangsqualitätskennzeichnenden Größen einen der Kopplungsfaktoren für das Felderzeugungselement des jeweilige Sendemoduls zu ermitteln. Diese Lösung ist besonders geeignet, wenn die geometrische Anordnung der Empfangsmodule in Bezug auf die Sendevorrichtung während der Energieübertragung variabel ist. Der Ermittlungsmodus kann dabei vor dem Energieübertragungsmodus verwendet werden, um den elektrischen Wirkungsgrad in dem nachfolgenden Energieübertragungsmodus zu optimieren. Weiterhin kann der Ermittlungsmodus ein oder mehrfach wiederholt werden, um auf eine Änderung der geometrischen Anordnung reagieren zu können.

Nach einer zweckmäßigen Weiterbildung der Erfindung ist die Steuereinrichtung in einem Ermittlungsmodus zur Ermittlung der Kopplungsfaktoren ausgebildet, wobei die Steuereinrichtung im Ermittlungsmodus zur sequentiellen Durchführung von Ermittlungssequenzen für mehrere oder für alle der Sendemodule ausgebildet ist, wobei bei jeder der Ermittlungssequenzen durch die Steuereinrichtung ausschließlich die elektrische Energiequelle des jeweiligen Sendemoduls angesteuert ist, wobei bei jeder der Ermittlungssequenzen alle oder mehrere der Feldempfangselemente eine empfangsqualitätskennzeichnende Größe an die Steuereinrichtung überträgt und wobei bei jeder der Ermittlungssequenzen die Steuereinrichtung aus jeder der empfangsqualitätskennzeichnenden Größen einen der Kopplungsfaktoren für das Felderzeugungselement des jeweiligen Sendemoduls ermittelt.

Es ergeben sich die oben beschriebenen Vorteile.

Nach einer zweckmäßigen Weiterbildung der Erfindung weist wenigstens eines der Empfangsmodule einen einstellbaren Lastwiderstand auf, wobei das jeweilige Empfangsmodul zur Einstellung des jeweiligen Lastwiderstandes in Abhängigkeit von der Kopplungsmatrix ausgebildet ist.

Auf diese Weise kann der elektrische Wirkungsgrad weiter verbessert werden.

Im Folgenden werden die vorliegende Erfindung und deren Vorteile anhand von Figuren näher beschrieben.

Es zeigen:

Figur 1 ein erstes Ausführungsbeispiel eines erfindungsgemäßen Energieübertragungssystems zum kontaktlosen Übertragen von elektrischer Energie mittels induktiver Kopplung oder mittels kapazitiver Kopplung in einer schematischen Darstellung, welches eine beispielhafte erfindungsgemäße Sendevorrichtung umfasst;

Figur 2 ein allgemeines beispielhaftes Ersatzschaltbild eines erfindungsgemäßen Energieübertragungssystems;

Figur 3 ein weiteres allgemeines beispielhaftes Ersatzschaltbild eines erfindungsgemäßen Energieübertragungssystems;

Figur 4 ein zweites Ausführungsbeispiel eines erfindungsgemäßen Energieübertragungssystems in einer vereinfachten Teildarstellung;

Figur 5 eine beispielhafte Darstellung der Imaginäranteile der Streuimpedanzen des zweiten Ausführungsbeispiels; und

Figur 6 eine beispielhafte Darstellung der durch die Steuereinrichtung der Sendevorrichtung eingestellten Ströme und Spannungen der Welt Erzeugungselemente des zweiten Ausführungsbeispiels.

Gleiche oder gleichartige Elemente oder Elemente mit gleicher oder äquivalenter Funktion sind im Folgenden mit gleichen oder gleichartigen Bezugszeichen versehen.

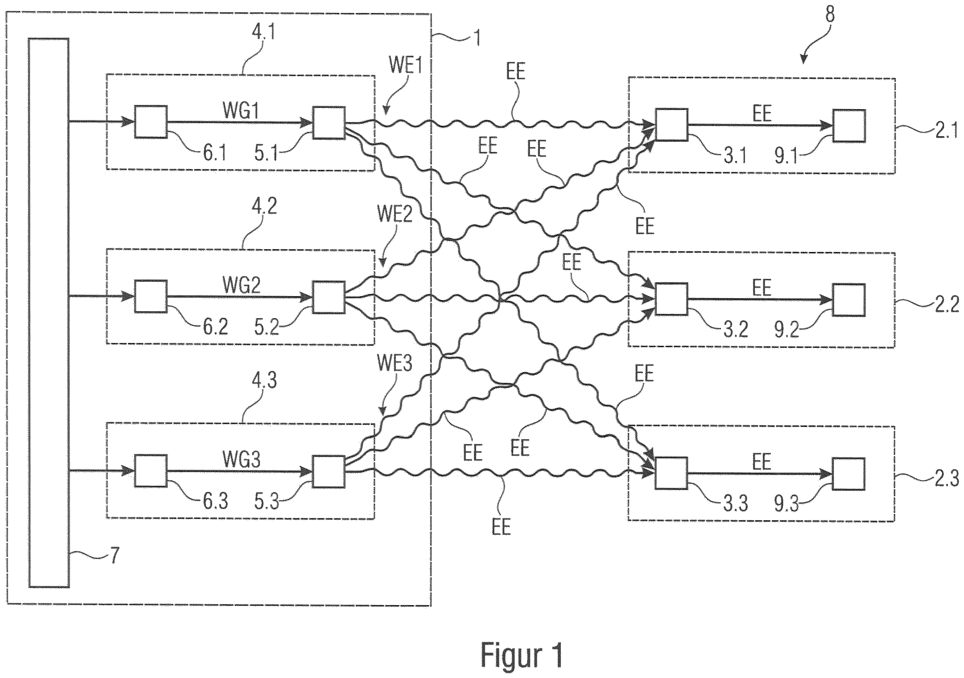

Figur 1 zeigt ein erstes Ausführungsbeispiel eines Energieübertragungssystems 8 zum kontaktlosen Übertragen von elektrischer Energie EE mittels induktiver Kopplung oder mittels kapazitiver Kopplung von einer Sendevorrichtung 1 des Energieübertragungssystems 8 an mehrere Empfangsmodule 2 des Energieübertragungssystems 8;

wobei die Empfangsmodule 2 jeweils ein Feldempfangselement 3 zum Empfangen von elektrischer Energie EE aufweisen;

wobei die Sendevorrichtung 1 eine Vielzahl von Sendemodulen 4 und eine Steuereinrichtung 7 umfasst;

wobei die Sendemodule 4 jeweils ein Felderzeugungselement 5 zum Erzeugen eines Wechselenergiefeldes WE und eine elektrische Energiequelle 6 zum drahtgebundenen Beaufschlagen des jeweiligen Felderzeugungselementes 5 mit einer elektrischen Wechselgröße WG umfassen;

wobei die Steuereinrichtung 7 in einem Energieübertragungsmodus zum derartigen Ansteuern der elektrischen Energiequellen 6 ausgebildet ist, dass mehrere der Sendemodule 4 gleichzeitig jeweils eines der Wechselenergiefelder WE erzeugen, wobei in dem Energieübertragungsmodus die elektrischen Wechselgrößen WG in Abhängigkeit von einer Kopplungsmatrix KM gesteuert sind, wobei die Kopplungsmatrix KM für mehrere oder für alle der Felderzeugungselemente 5 Kopplungsfaktoren KF zu mehreren oder zu allen der Feldempfangselemente 3 umfasst.

Gemäß der Erfindung weist das Energieübertragungssystem 8 mehrere Empfangsmodule 2 auf, wobei wenigstens eines der Empfangsmodule 2 ein parallel zum Feldempfangselement 3 geschaltetes einstellbares Kompensationselement aufweist, wobei das jeweilige Empfangsmodul 2 zur Einstellung des jeweiligen Kompensationselements in Abhängigkeit von einer Kreuzkopplungsmatrix KKM ausgebildet ist, wobei die Kreuzkopplungsmatrix KKM für mehrere oder alle der Feldempfangselemente 3 Kreuzkopplungsfaktoren KKF zu mehreren oder allen der anderen Feldempfangselemente 3 umfasst.

Gemäß einer zweckmäßigen Weiterbildung der Erfindung ist die Steuereinrichtung 7 in einem Ermittlungsmodus zur Ermittlung der Kopplungsfaktoren KF ausgebildet, wobei die Steuereinrichtung 7 im Ermittlungsmodus zur sequentiellen Durchführung von Ermittlungssequenzen für mehrere oder für alle der Sendemodule 4 ausgebildet ist, wobei bei jeder der Ermittlungssequenzen durch die Steuereinrichtung 7 ausschließlich die elektrische Energiequelle 5 des jeweiligen Sendemoduls 4 angesteuert ist, wobei bei jeder der Ermittlungssequenzen mehrere oder alle der Feldempfangselemente 3 eine empfangsqualitätskennzeichnende Größe an die Steuereinrichtung 7 übertragen und wobei bei jeder der Ermittlungssequenzen die Steuereinrichtung 7 aus allen oder mehreren der empfangsqualitätskennzeichnenden Größen einen der Kopplungsfaktoren KF für das Felderzeugungselement 5 des jeweiligen Sendemoduls 4 ermittelt.

Nach einer vorteilhaften Weiterbildung der Erfindung weist wenigstens eines der Empfangsmodule 2 einen einstellbaren Lastwiderstand 9 auf, wobei das jeweilige Empfangsmodul 2 zur Einstellung des jeweiligen Lastwiderstandes 9 in Abhängigkeit von der Kopplungsmatrix KM ausgebildet ist.

Gemäß einer vorteilhaften Weiterbildung der Erfindung ist die Steuereinrichtung 7 zum derartigen Ansteuern der elektrischen Energiequellen 5 ausgebildet ist, dass in dem Energieübertragungsmodus die elektrischen Wechselgrößen WG in Abhängigkeit von einer Singulärwertzerlegung einer von einer Kopplungsmatrix KM abhängigen Matrix gesteuert sind ausgebildet.

Gemäß einer vorteilhaften Weiterbildung der Erfindung ist die Steuereinrichtung 7 für jedes der Sendemodule 4 zur Steuerung einer Amplitude der jeweiligen elektrischen Wechselgröße WG ausgebildet.

Nach einer zweckmäßigen Weiterbildung der Erfindung ist die Steuereinrichtung 7 für jedes der Sendemodule 4 zur Steuerung einer Phase der jeweiligen elektrischen Wechselgröße ausgebildet.

Gemäß einer vorteilhaften Weiterbildung der Erfindung sind die Felderzeugungselemente 5 Spulen, welche jeweils das jeweilige Wechselenergiefeld WE in Form eines magnetischen Wechselfeldes erzeugen.

Nach einer zweckmäßigen Weiterbildung der Erfindung sind die Felderzeugungselemente 5 Kapazitäten, welche jeweils das jeweilige Wechselenergiefeld 5 in Form eines elektrischen Wechselfeldes erzeugen.

Gemäß einer vorteilhaften Weiterbildung der Erfindung ist in dem Energieübertragungsmodus die elektrischen Wechselgrößen WG die von der Kopplungsmatrix KM abhängige Matrix abhängig von einer Kreuzkopplungsmatrix KKM, wobei die Kreuzkopplungsmatrix KKM für mehrere oder für alle der Feldempfangselemente 3 Kreuzkopplungsfaktoren KKF zu mehreren oder zu allen der anderen Feldempfangselemente 3 umfasst.

Nach einer zweckmäßigen Weiterbildung der Erfindung ist zumindest ein Teil der Kopplungsfaktoren KF in der Steuereinrichtung 7 hinterlegt.

Gemäß einer vorteilhaften Weiterbildung der Erfindung ist die Steuereinrichtung 7 in einem Ermittlungsmodus zur Ermittlung wenigstens eines Teils der Kopplungsfaktoren KF ausgebildet, wobei die Steuereinrichtung 7 im Ermittlungsmodus zur sequentiellen Durchführung von Ermittlungssequenzen für mehrere oder für alle der Sendemodule 4 ausgebildet ist, wobei bei jeder der Ermittlungssequenzen durch die Steuereinrichtung 7 ausschließlich die elektrische Energiequelle 6 des jeweiligen Sendemoduls 4 angesteuert ist und durch die Steuereinrichtung 7 von mehreren oder von allen der Feldempfangselemente 3 eine empfangsqualitätskennzeichnende Größe empfangen ist, um aus jeder der empfangsqualitätskennzeichnenden Größen einen der Kopplungsfaktoren KF für das Felderzeugungselement 5 des jeweilige Sendemoduls 4 zu ermitteln.

Im ersten Ausführungsbeispiel umfasst das Energieübertragungssystem 8 die Sendevorrichtung 1, welche ihrerseits drei Sendemodule 4.1, 4.2 und 4.3 umfasst. Das Sendemodul 4.1 umfasst das Felderzeugungselement 5.1 sowie die Energiequelle 6.1 und erzeugt das Wechselenergiefeld WE1. Das Sendemodul 4.2 umfasst das Felderzeugungselement 5.2 sowie die Energiequelle 6.2 und erzeugt das Wechselenergiefeld WE2. Weiterhin umfasst das Sendemodul 4.3 das Felderzeugungselement 5.3 sowie die Energiequelle 6.3 und erzeugt das Wechselenergiefeld WE3.

Dabei umfasst das Energieübertragungssystem 8 drei Empfangsmodule 2.1, 2.2, und 2.3. Das Empfangsmodul 2.1 umfasst ein Feldempfangselement 3.1 und einen Lastwiderstand 9.1. Das Empfangsmodul 2.2 umfasst ein Feldempfangselement 3.2 und einen Lastwiderstand 9.2. Weiterhin umfasst das Empfangsmodul 2.3 ein Feldempfangselement 3.3 und einen Lastwiderstand 9.3.

Jedes der Wechselenergiefelder WE1, WE2 und WE3 überträgt dabei simultan elektrische Energie EE an jedes der Feldempfangselemente 3.1, 3.2 und 3.3. Das Feldempfangselement 3.1 überträgt den empfangenen Teil der elektrischen Energie EE an den Lastwiderstand 9.1. Das Feldempfangselement 3.2 überträgt den empfangenen Teil der elektrischen Energie EE an den Lastwiderstand 9.2. Weiterhin überträgt das Feldempfangselement 3.3 den empfangenen Teil der elektrischen Energie EE an den Lastwiderstand 9.3.

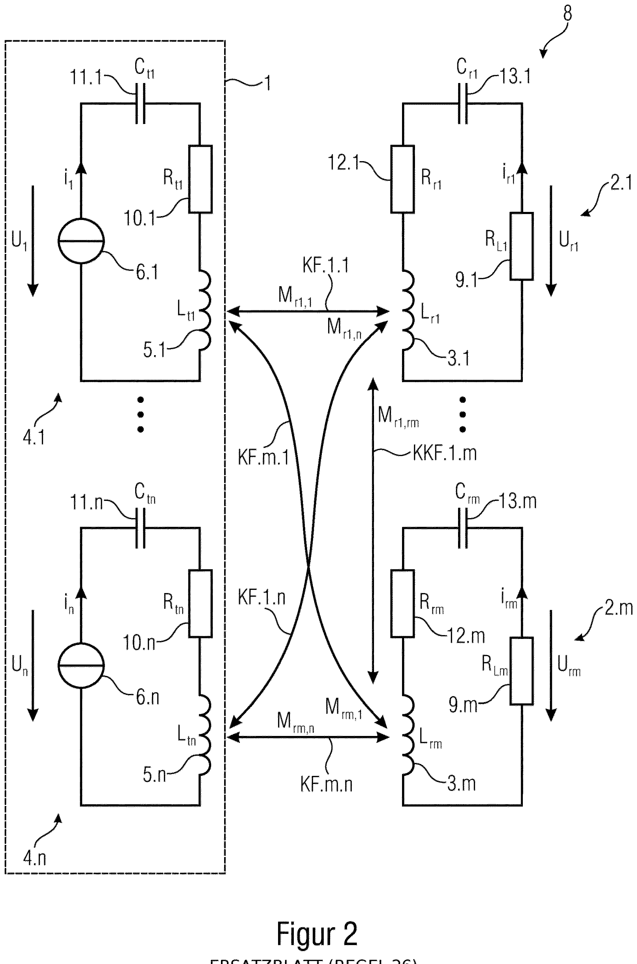

Figur 2 zeigt ein allgemeines beispielhaftes Ersatzschaltbild eines erfindungsgemäßen Energieübertragungssystems 8. Gezeigt ist eine drahtlose Energieübertragung mit einer Sendevorrichtung 1 mit mehreren Sendemodulen 4.1 bis 4.n, welche jeweils ein als Sendespule ausgebildetes Felderzeugungselement 5.1 bis 5 aufweisen und mit einem oder mehreren Empfangsvorrichtungen mit jeweils mehreren Empfangsmodulen 2.1 bis 2.m, welche jeweils ein als Empfangsspule ausgebildetes Feldempfangselement kann 3.1 bis 3.m aufweisen.

In den folgenden Betrachtungen werden monofrequente Signale betrachtet, die eine Phasenbeziehung zu einem festen Referenzsignal besitzen. Aus Gründen der Darstellung werden die Signale als komplexe Amplituden betrachtet. Alle Betrachtungen dienen der Maximierung der Effizienz der Energieübertragung.

Es wird lediglich die elektrische Effizienz betrachtet. Diese ist gleich dem Quotienten aus der in das System eingespeisten Energie und der dem System entnommenen Energie.

In den folgenden Betrachtungen wird die drahtlose Energieübertragung über Spulen betrachtet. Die gleichen Formeln gelten aber auch analog für die kapazitive Energieübertragung. Die Energieübertragung wird resonant betrieben, dies dient in erster Linie der Energieübertragung über größere Distanzen. Jedoch ist dies nicht zwingend erforderlich für die Betrachtungen.

Aufgrund der Betrachtung von Spulen wird die Streuinduktivität $M$ zwischen diesen betrachtet. Dabei ist $M_{i,j}$ die Streuinduktivität zwischen Spule $i$ und Spule $j$. $M_{i,i}$ ist dabei die Selbstinduktivität der Spule i. Die Selbstinduktivität wird aber, sofern nicht anders erwähnt als kompensiert betrachtet.

Nichtsdestotrotz hat die Selbstinduktivität der Sendespulen keinen Einfluss auf die Effizienz des Energieübertragungssystems 8. Der Einfluss besteht lediglich auf die benötigte Blindleistung, welche aber keinen Einfluss auf den Spulen Wirkungsgrad oder auf den optimal gewählten Strom, besitzt.

Für die kompakte Darstellung der Rechnungen wird die Selbstinduktivität daher als null angenommen.

Die Ströme werden mit $I$ bezeichnet. Der Index gibt an welcher Strom betrachtet wird. Das Gleiche gilt auch für die Spannungen und Ohm'schen Verluste $R$ in den Spulen.

Der Index $r$ wird abkürzend für den Empfänger (eng. receiver) verwendet. Der Index $t$ wird abkürzend für den Sender (eng. transmitter) verwendet.

Als Senke der Energieübertragung wird in dem System empfangsseitig $R\_L$ als Lastwiderstand 9 verwendet. Dieser steht stellvertretend für den Verbraucher in dem System.

Das Energieübertragungssystem 8 umfasst eine Sendevorrichtung 1, welche n-Sendemodule 4.1 bis 4.n umfasst. Darüber hinaus umfasst das Energieübertragungssystem 8 m-Empfangsmodule 2.1 bis 2.m.

Das Sendemodul 4.1 umfasst ein Felderzeugungselement 5.1, welches hier als Spule mit dem Wert $L_{t1}$ ausgebildet ist, eine Energiequelle 6.1, welche als Spannungsquelle oder als Stromquelle ausgebildet sein kann, einen Verlustwiderstand 10.1 mit dem Wert $R_{t1}$ und eine Senderkapazität 11.1 mit dem Wert $C_{t1}$. Dabei liegt an der Energiequelle 6.1 die Spannung $U_1$ an und es fließt der Strom $i_1$. Das Sendemodul 4.n umfasst ein Felderzeugungselement 5.n, welches hier als Spule mit dem Wert $L_{tn}$ ausgebildet ist, eine Energiequelle 6.n, welche als Spannungsquelle oder als Stromquelle ausgebildet sein kann, einen Verlustwiderstand 10.n mit dem Wert $R_{tn}$ und eine Senderkapazität 11.n mit dem Wert $C_{tn}$. Dabei liegt an der Energiequelle 6.n die Spannung $U_n$ an und es fließt der Strom $i_n$.

Das Empfangsmodul 2.1 umfasst ein Feldempfangselement 3.1, welches hier als Spule mit dem Wert $L_{r1}$ ausgebildet ist, einen Lastwiderstand 11.1 mit dem Wert $R_{L1}$, einen Verlustwiderstand 12.1 mit dem Wert $R_{r1}$ und eine Empfängerkapazität 13.1 mit dem Wert $C_{r1}$. Dabei liegt an dem Lastwiderstand 9.1 die Spannung $U_{r1}$ an und es fließt der Strom $i_{r1}$. Das Empfangsmodul 2.m umfasst ein Feldempfangselement 3.m, welches hier als Spule mit dem Wert $L_{rm}$ ausgebildet ist, einen Lastwiderstand 11.m mit dem Wert $R_{Lm}$, einen Verlustwiderstand 12.m mit dem Wert $R_{rm}$ und eine Empfängerkapazität 13.m mit dem Wert $C_{rm}$. Dabei liegt an dem Lastwiderstand 9.m die Spannung $U_{rm}$ an und es fließt der Strom $i_{rm}$.

$M_{r1.1}$ ist der Kopplungsfaktor KF.1.1 zwischen dem Sendemodul 4.1 und dem Empfangsmodul 2.1, $M_{rm.1}$ ist der Kopplungsfaktor KF.m.1 zwischen dem Sendemodul 4.1 und dem Empfangsmodul 2.m, $M_{r1.n}$ ist der Kopplungsfaktor KF.1.n zwischen dem Sendemodul 4.n und dem Empfangsmodul 2.1 und $M_{rm.n}$ ist der Kopplungsfaktor KF.m.n zwischen dem Sendemodul 4.n und dem Empfangsmodul 2.m,

$M_{r1.rm}$ ist der Kreuzkopplungsfaktor KKF.1.m zwischen dem Empfangsmodul 2.1 und dem Empfangsmodul 2.m.

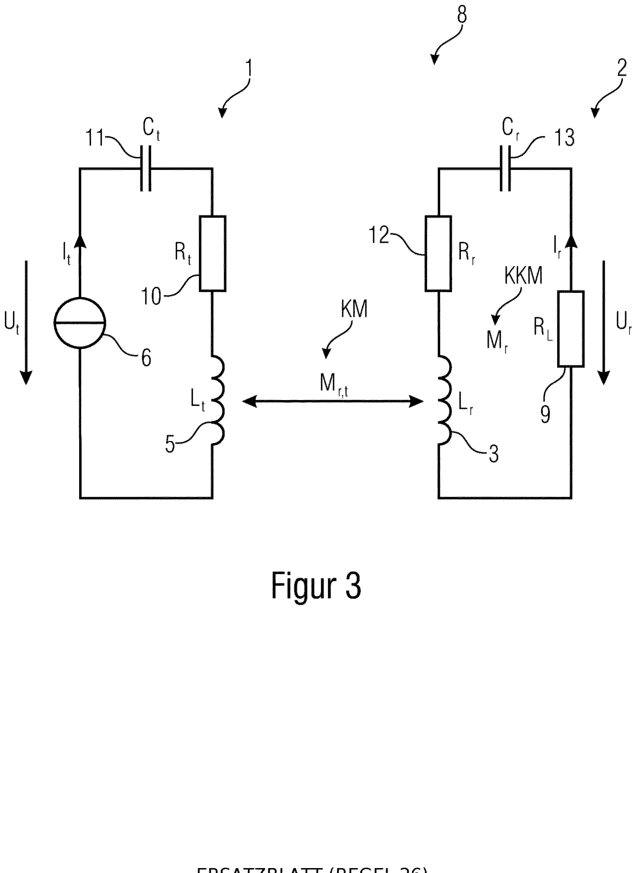

Figur 3 zeigt ein weiteres allgemeines beispielhaftes Ersatzschaltbild eines erfindungsgemäßen Energieübertragungssystems. Zur kompakten Darstellung werden mehrdimensionale Größen verwendet. So werden die Kopplungsfaktoren KF von den Sendemodulen 4.1 bis 4.n zu den Empfangsmodulen 2.1 bis 2.m zu $M_{t,r}$ zusammengefasst, was die Kopplungsmatrix KM ergibt. Die Werte der Kreuzkopplungsfaktoren zwischen den Empfangsmodulen 2.1 bis 2.m sind zu $M_r$ zusammengefasst, was die Kreuzkopplungsmatrix KKM ergibt.

Die Werte der Felderzeugungselemente 5.1 bis 5.n sind zu dem Vektor $L_t$ zusammengefasst. Die Werte der Verlustwiderstände 10.1 bis 10.n der Sendemodule 4.1 bis 4.n sind zum Vektor $R_t$ zusammengefasst. Die Werte der Senderkapazitäten 11.1 bis 11.n sind zum Vektor $C_t$ zusammengefasst. Die Werte der Spannungen und Ströme an den Energiequellen 6.1 bis 6.m sind zu den Vektoren $U_t$ und $I_t$ zusammengefasst.

Die Werte der Feldempfangselemente 3.1 bis 3.m sind zu dem Vektor $L_r$ zusammengefasst. Die Werte der Lastwiderstände 9.1 bis 9.m der Empfangsmodule 2.1 bis 2.m sind zum Vektor $R_r$ zusammengefasst. Die Werte der Verlustwiderstände 12.1 bis 12.m der Empfangsmodule 2.1 bis 2.m sind zum Vektor $R_L$ zusammengefasst. Die Werte der Empfängerkapazitäten 13.1 bis 13.m sind zum Vektor $C_r$ zusammengefasst. Die Werte der empfängerseitigen Spannungen und Ströme sind zu den Vektoren $U_r$ und $I_r$ zusammengefasst.

Es ergeben sich folgende Strom-Spannungsbeziehungen:

$$\begin{bmatrix} U_t \\ U_r \end{bmatrix} = \begin{bmatrix} U_t \\ -R_L I_r \end{bmatrix} = \mathrm{j}\omega \begin{bmatrix} 0 & M_{r,t} \\ M_{r,t} & 0 \end{bmatrix} \begin{bmatrix} I_t \\ I_r \end{bmatrix}$$

Der Wert *PTE* des Wirkungsgrads, welcher maximiert wird, ist folgender:

$$\mathrm{PTE} = \frac{\mathbf{I}_r^H \mathbf{R}_L \mathbf{I}_r}{\mathbf{I}_t^H \mathbf{R}_t \mathbf{I}_t + \mathbf{I}_r^H (\mathbf{R}_r + \mathbf{R}_L) \mathbf{I}_r}$$

Die Singulärwertzerlegung kann durch folgende Gleichung beschrieben werden:

$$\mathbf{U}\Lambda\mathbf{V}^H = \mathbf{R}_t^{-1/2}\mathbf{M}_{r,t}^H(\mathbf{R}_r + \mathbf{R}_L - \mathrm{j}\omega\mathbf{M}_{r,r})^{-1}\mathbf{R}_L^{1/2} \, ,$$

wobei die rechte Seite die von der Kopplungsmatrix KM abhängige Matrix ist, wobei $U$ eine unitäre Matrix ist, wobei $\Lambda$ eine reelle Diagonalmatrix ist und wobei $V^H$ eine Adjungierte einer unitären Matrix ist. Sofern die Kreuzkopplungsfaktoren KKF vernachlässigbar klein sind, kann der Term $-j\omega M_{r,r}$ auch weggelassen werden.

Die optimale Verteilung der Ströme für die Sendemodule 4,1 bis 4.n ergeben sich durch folgende Beziehung:

$$\mathbf{I}_t \propto \mathbf{R}_t^{-1/2}\mathbf{u}_1 \, ,$$

wobei $u_1$ der erste Spaltenvektor der Matrix $U$ ist. Die Werte der Ströme lassen sich dann aus der geforderten Leistung berechnen.

Falls die Sendemodule 4.1 bis 4.n baugleich sind, bzw. dieselben elektrischen Eigenschaften aufweisen und lediglich ein Empfangsmodul 2 vorgesehen ist, vereinfacht sich die Bestimmung der optimalen Stromverteilung. Die Stromverteilung ist dann proportional zu den Werten der dann eindimensionalen Kopplungsmatrix KM, wobei gilt:

$$\mathbf{I}_t = \mathbf{M}_{r,t}^H \cdot \mathrm{const} \, .$$

Die optimale Spannungsverteilung für die Sendemodule 4.1 bis 4.n kann aus der optimalen Stromverteilung errechnet werden:

$$\mathbf{U}_t = \mathrm{j}\omega \begin{bmatrix} \mathbf{M}_{t,t} & \mathbf{M}_{r,t}^T \end{bmatrix} \begin{bmatrix} \mathbf{I}_t \\ \mathbf{I}_r \end{bmatrix} + \mathbf{R}_t\mathbf{I}_t$$

Der optimale Lastwiderstand 9.1 bis 9.m für Empfangsmodule 2 ergibt sich nach folgender Formel:

$$R_{Lk} = R_{rk}\sqrt{1 + \omega^2 \frac{\mathbf{I}_t^H\mathbf{M}_{r,t}^H\mathbf{R}_r^{-1}\mathbf{M}_{r,t}\mathbf{I}_t}{\mathbf{I}_t^H\mathbf{R}_t\mathbf{I}_t}}$$

Hierbei wurde aber angenommen, dass die Feldempfangselemente 3.1 bis 3.m eine Vernachlässigbare Kreuzstreuimpedanz zueinander haben. Diese Einschränkung kann fallengelassen werden, wenn ein weiteres Kompensationselement mit einer Impedanz mit Wert $X$ verwendet wird. Diese können jeweils in Reihe zu einem der Feldempfangselemente 3.1 bis 3.m geschaltet werden. Die Werte X können für den den k-ten Empfänger aller m Empfänger wie folgt berechnet werden:

$$X_k = -\frac{1}{I_{rk}}\sum_{i=1}^{m} M_{rk,ri}\, I_{ri}$$

wobei $I_{ri}$ für den Strom im $i$-ten Empfangsmodul 2 bis 2.m steht, welcher fließt, wenn keine Kreuzstreuimpedanzen zwischen den Feldempfangselementen 3.1 bis 3.m existieren.

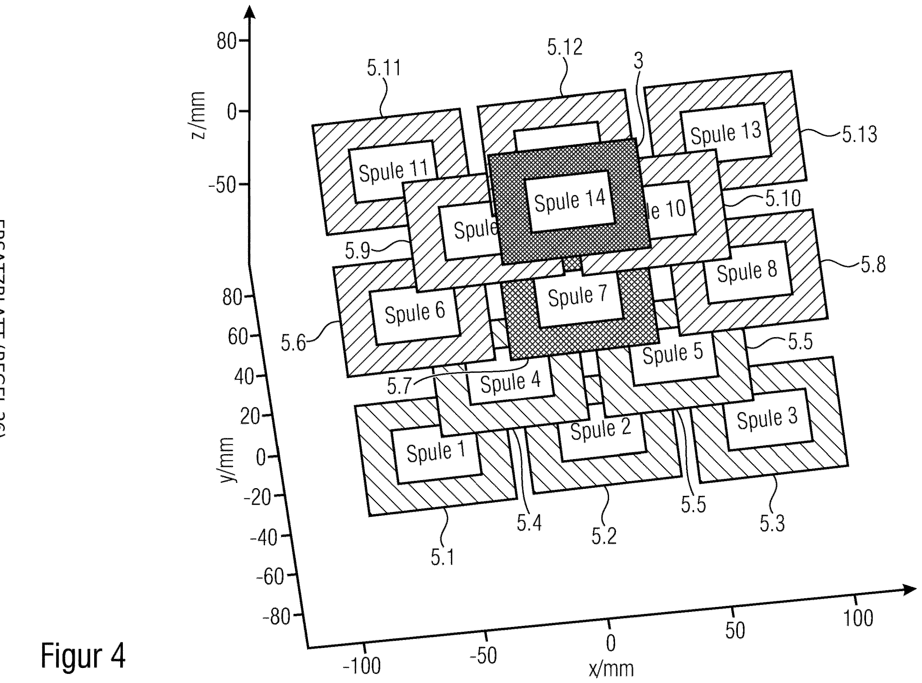

Figur 4 zeigt ein zweites Ausführungsbeispiel eines erfindungsgemäßen Energieübertragungssystems 8 in einer vereinfachten Teildarstellung. Dargestellt sind dreizehn 5.1 bis 5.13, welche jeweils als Spulen ausgebildet sind. Weiterhin dargestellt ist ein Feldempfangselement 3, welches ebenfalls als Spule ausgebildet ist.

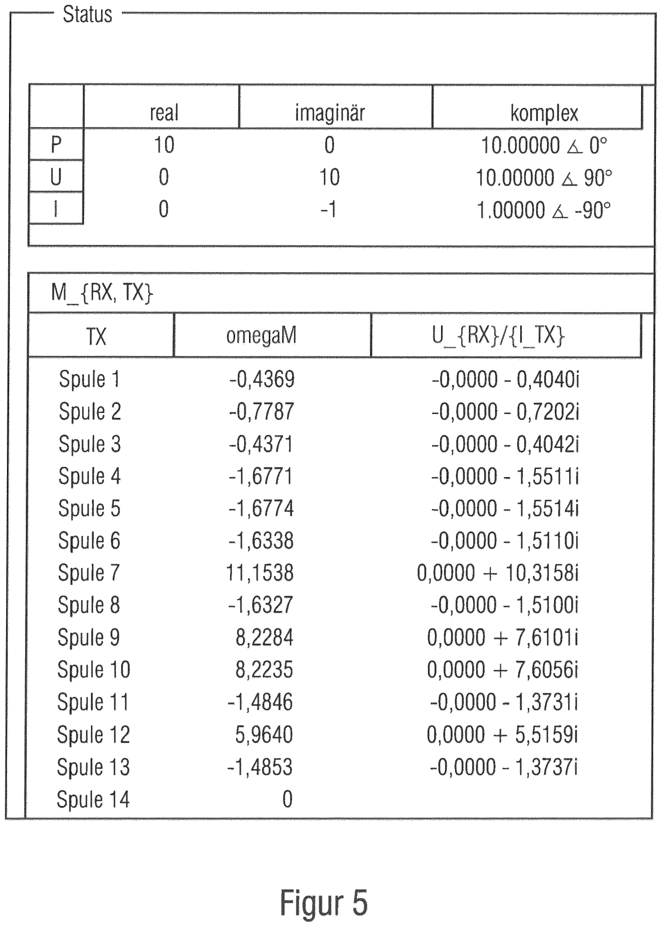

Figur 5 zeigt eine beispielhafte Darstellung der Imaginäranteile der Streuimpedanzen des zweiten Ausführungsbeispiels, welche mittels einer Simulation ermittelt wurden. Im Beispiel soll eine Wirkleistung von 10 W bei einer Spannung von 10 V und einem Strom von 1 A übertragen werden. In der Spalte "TX" sind die Bezeichnungen der Felderzeugungselemente 5.1 bis 5.13 sowie des Feldempfangselement 3 angegeben. In der Spalte "omegaM" sind die jeweils zugehörigen Imaginäranteile der Streuimpedanzen dargestellt. In der Spalte "U_{RX]/{I_TX}" der berechnete Realteil und der berechnete Imaginäranteil des Verhältnisses der Spannung am Lastwiderstand 9 des Empfangsmoduls 2 und der Ströme in den Sendemodulen 4.1 bis 5.13 der Sendevorrichtung 1.

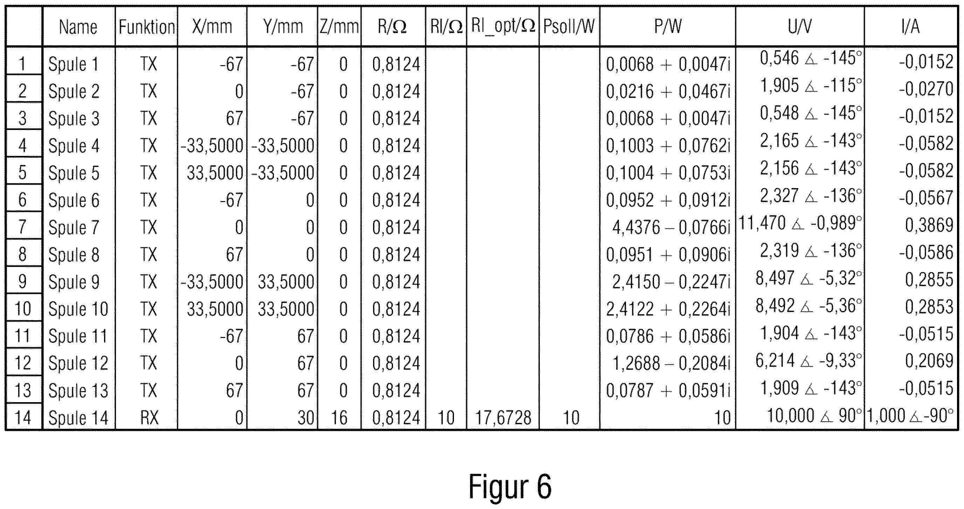

Figur 6 zeigt eine beispielhafte Darstellung der durch die Steuereinrichtung 7 der Sendevorrichtung 1 eingestellten Ströme und Spannungen des zweiten Ausführungsbeispiels, welche mittels einer Simulation ermittelt wurden. In der Spalte "Name" sind die Bezeichnungen der Felderzeugungselemente 5.1 bis 5.13 sowie des Feldempfangselement 3 angegeben. In den Spalten "X", "Y" und "Z" sind die Positionen der Felderzeugungselemente 5.1 bis 5.13 sowie des Feldempfangselement 3 angegeben. Weiterhin sind in der Spalte "R" die Verlustwiderstände 10.1 bis 10.13 der Felderzeugungselemente 5.1 bis 5.13 sowie der Verlustwiderstand 12 des Feldempfangselement 3 dargestellt. In der Spalte "RI" ist der Lastwiderstand 9 des Empfangsmoduls 2 dargestellt. Weiterhin ist in der Spalte "RI_opt" der optimale Lastwiderstand 9 des Empfangsmodul 2 dargestellt. In den Spalten "P", "U" und "I" sind schließlich die Leistung, die Spannung und der Strom in den Modulen 2 und 4.1 bis 4.13 dargestellt. Es ergibt sich ein sehr hoher elektrischer Wirkungsgrad von 0,9.

In der folgenden Beschreibung werden Ausführungsbeispiele mit einer Vielzahl von Merkmalen der vorliegenden Erfindung näher beschrieben, um ein besseres Verständnis der Erfindung zu vermitteln. Es ist jedoch festzuhalten, dass die vorliegende Erfindung auch unter Auslassung einzelner der beschriebenen Merkmale umgesetzt werden kann. Es sei auch darauf hingewiesen, dass die in verschiedenen Ausführungsbeispielen gezeigten Merkmale auch in anderer Weise kombinierbar sind, sofern dies nicht ausdrücklich ausgeschlossen ist oder zu Widersprüchen führen würde.

Aspekte der Erfindung, welche im Zusammenhang mit einer Sendevorrichtung beschrieben sind, betreffen auch das korrespondierende Energieübertragungssystem. Umgekehrt betreffen auch solche Aspekte der Erfindung, welche im Zusammenhang mit dem Energieübertragungssystem beschrieben sind, auch die korrespondierende Sendevorrichtung.

Bezugszeichen:

| | |
|---|---|
| 1 | Sendevorrichtung |
| 2 | Empfangsmodul |
| 3 | Feldempfangselement |
| 4 | Sendemodul |
| 5 | Felderzeugungselement |
| 6 | Energiequelle |
| 7 | Steuereinrichtung |
| 8 | Energieübertragungssystem |
| 9 | Lastwiderstand |
| 10 | Verlustwiderstand |
| 11 | Senderkapazität |
| 12 | Verlustwiderstand |
| 13 | Empfängerkapazität |
| EE | elektrische Energie |
| WE | Wechselenergiefeld |
| WG | elektrische Wechselgröße |
| KF | Kopplungsfaktor |
| KM | Kopplungsmatrix |
| KKF | Kreuzkopplungsfaktor |
| KKM | Kopplungsmatrix |

Referenzen:

[1] DE102016221225A1
[2] DE102018219460A1
[3] US9013068B2
[4] EP2346136A1
[5] KR101916636B1
[6] WO2017171435A1
[7] CN104485507A
[8] KR102029919B1

[9] US10425837B2

[10] US000010230271B2

[11] KR101932383B1

[12] EP3054559A1

[13] DOI: 10.1109/TII.2016.2516906

[14] DOI: 10.1109/TMTT.2015.2398422

[15] DOI: 10.1109/WPT.2014.6839600

[16] DOI: 10.1109/ICASSP.2016.7472415

[17] https://www.comm.utoronto.ca/-rsadve/Notes/BeamForming.pdf

[18] US2018323637A1

[19] CN110620446A

[20] US2015236526A1

**Patentansprüche**

1. Energieübertragungssystem zum kontaktlosen Übertragen von elektrischer Energie (EE) mittels induktiver Kopplung oder mittels kapazitiver Kopplung von einer Sendevorrichtung (1) des Energieübertragungssystems (8) an mehrere Empfangsmodule (2) des Energieübertragungssystems (8);

   wobei die Empfangsmodule (2) jeweils ein Feldempfangselement (3) zum Empfangen von elektrischer Energie (EE) aufweisen;
   wobei die Sendevorrichtung (1) eine Vielzahl von Sendemodulen (4) und eine Steuereinrichtung (7) umfasst;
   wobei die Sendemodule (4) jeweils ein Felderzeugungselement (5) zum Erzeugen eines Wechselenergiefeldes (WE) und eine elektrische Energiequelle (6) zum drahtgebundenen Beaufschlagen des jeweiligen Felderzeugungselementes (5) mit einer elektrischen Wechselgröße (WG) umfassen;
   wobei die Steuereinrichtung (7) in einem Energieübertragungsmodus zum derartigen Ansteuern der elektrischen Energiequellen (6) ausgebildet ist, dass mehrere der Sendemodule (4) gleichzeitig jeweils eines der Wechselenergiefelder (WE) erzeugen, wobei in dem Energieübertragungsmodus die elektrischen Wechselgrößen (WG) in Abhängigkeit von einer Kopplungsmatrix (KM) gesteuert sind, wobei die Kopplungsmatrix (KM) für mehrere oder für alle der Felderzeugungselemente (5) Kopplungsfaktoren (KF) zu mehreren oder zu allen der Feldempfangselemente (3) umfasst;
   **dadurch gekennzeichnet,**
   **dass** wenigstens eines der Empfangsmodule (2) ein parallel oder in Reihe zum Feldempfangselement (3) geschaltetes einstellbares Kompensationselement aufweist, wobei das jeweilige Empfangsmodul (2) zur Einstellung des jeweiligen Kompensationselements in Abhängigkeit von einer Kreuzkopplungsmatrix (KKM) ausgebildet ist, wobei die Kreuzkopplungsmatrix (KKM) für mehrere oder alle der Feldempfangselemente (3) Kreuzkopplungsfaktoren (KKF) zu mehreren oder allen der anderen Feldempfangselemente (3) umfasst.

2. Energieübertragungssystem nach Anspruch 1, wobei die Steuereinrichtung (7) in einem Ermittlungsmodus zur Ermittlung der Kopplungsfaktoren (KF) ausgebildet ist, wobei die Steuereinrichtung (7) im Ermittlungsmodus zur sequentiellen Durchführung von Ermittlungssequenzen für mehrere oder für alle der Sendemodule (4) ausgebildet ist, wobei bei jeder der Ermittlungssequenzen durch die Steuereinrichtung (7) ausschließlich die elektrische Energiequelle (5) des jeweiligen Sendemoduls (4) angesteuert ist, wobei bei jeder der Ermittlungssequenzen mehrere oder alle der Feldempfangselemente (3) eine empfangsqualitätskennzeichnende Größe an die Steuereinrichtung (7) übertragen und wobei bei jeder der Ermittlungssequenzen die Steuereinrichtung (7) aus allen oder mehreren der empfangsqualitätskennzeichnenden Größen einen der Kopplungsfaktoren (KF) für das Felderzeugungselement (5) des jeweiligen Sendemoduls (4) ermittelt.

3. Energieübertragungssystem nach Anspruch 1 oder 2, wobei wenigstens eines der Empfangsmodule (2) einen einstellbaren Lastwiderstand (9) aufweist, wobei das jeweilige Empfangsmodul (2) zur Einstellung des jeweiligen Lastwiderstandes (9) in Abhängigkeit von der Kopplungsmatrix (KM) ausgebildet ist.

4. Energieübertragungssystem nach einem der vorstehenden Ansprüche, wobei die Steuereinrichtung (7) zum derartigen Ansteuern der elektrischen Energiequellen (5) ausgebildet ist, dass in dem Energieübertragungsmodus die elektrischen Wechselgrößen (WG) in Abhängigkeit von einer Singulärwertzerlegung einer von einer Kopplungsmatrix (KM) abhängigen Matrix gesteuert sind ausgebildet ist.

5. Energieübertragungssystem nach einem der vorstehenden Ansprüche, wobei die Steuereinrichtung (7) für jedes der Sendemodule (4) zur Steuerung einer Amplitude der jeweiligen elektrischen Wechselgröße (WG) ausgebildet ist.

6. Energieübertragungssystem nach einem der vorstehenden Ansprüche, wobei die Steuereinrichtung (7) für jedes der Sendemodule (4) zur Steuerung einer Phase der jeweiligen elektrischen Wechselgröße ausgebildet ist.

7. Energieübertragungssystem nach einem der vorstehenden Ansprüche, wobei die Felderzeugungselemente (5) Spulen sind, welche jeweils das jeweilige Wechselenergiefeld (WE) in Form eines magnetischen Wechselfeldes erzeugen.

8. Energieübertragungssystem nach einem der Ansprüche 1 bis 6, wobei die Felderzeugungselemente (5) Kapazitäten sind, welche jeweils das jeweilige Wechselenergiefeld (5) in Form eines elektrischen Wechselfeldes erzeugen.

9. Energieübertragungssystem nach einem der vorstehenden Ansprüche, wobei in dem Energieübertragungsmodus die von der Kopplungsmatrix (KM) abhängige Matrix abhängig von einer Kreuzkopplungsmatrix (KKM) ist, wobei die Kreuzkopplungsmatrix (KKM) für mehrere oder für alle der Feldempfangselemente (3) Kreuzkopplungsfaktoren (KKF) zu mehreren oder zu allen der anderen Feldempfangselemente (3) umfasst.

10. Energieübertragungssystem nach einem der vorstehenden Ansprüche, wobei zumindest ein Teil der Kopplungsfaktoren (KF) in der Steuereinrichtung (7) hinterlegt ist.

**Claims**

1. Energy transmission system for contactless transmission of electrical energy (EE) by means of inductive coupling or by means of capacitive coupling from a transmitting device (1) of the energy transmission system (8) to a plurality of receiving modules (2) of the energy transmission system (8);

   wherein the receiving modules (2) each comprise a field receiving element (3) for receiving electrical energy (EE);
   wherein the transmitting device (1) includes a plurality of transmitting modules (4) and a control device (7);
   wherein the transmitting modules (4) each include a field generating element (5) for generating an alternating energy field (WE) and an electrical energy source (6) for applying in a wired manner an electrical alternating variable (WG) to the respective field generating element (5);
   wherein, in an energy transmission mode, the control device (7) is configured for driving the electrical energy sources (6) in such a way that a plurality of the transmitting modules (4) simultaneously each generate one of the alternating energy fields (WE), wherein, in the energy transmission mode, the electrical alternating variables (WG) are controlled as a function of a coupling matrix (KM), wherein the coupling matrix (KM) for a plurality of or for all of the field generating elements (5) includes coupling factors (KF) to several of or to all of the field receiving elements (3);
   **characterized in that**
   at least one of the receiving modules (2) comprises an adjustable compensation element connected in parallel or in series with the field receiving element (3), wherein the respective receiving module (2) is configured for adjusting the respective compensation element as a function of a cross-coupling matrix (KKM), wherein the cross-coupling matrix (KKM) for several of or for all of the field receiving elements (3) includes cross-coupling factors (KKF) to several of or to all of the other field receiving elements (3).

2. Energy transmission system according to claim 1, wherein, in a determination mode, the control device (7) is configured for determining the coupling factors (KF), wherein, in the determination mode, the control device (7) is configured for sequentially carrying out determination sequences for several of or for all of the transmitting modules (4), wherein, in each of the determination sequences, exclusively the electrical energy source (5) of the respective transmitting module (4) is driven by the control device (7), wherein, in each of the determination sequences, several of or all of the field receiving elements (3) transmit a variable characterizing the reception quality to the control device (7), and wherein, in each of the determination sequences, the control device (7) determines one of the coupling factors (KF) for the field generating element (5) of the respective transmitting module (4) from all or several of the variables characterizing the reception quality.

3. Energy transmission system according to claim 1 or 2, wherein at least one of the receiving modules (2) comprises an adjustable load resistor (9), wherein the respective receiving module (2) is configured for adjusting the respective load resistor (9) as a function of the coupling matrix (KM).

4.  Energy transmission system according to one of the preceding claims, wherein the control device (7) is configured for driving the electrical energy sources (5) in such a way that, in the energy transmission mode, the electrical alternating variables (WG) are controlled as a function of a singular value decomposition of a matrix dependent on a coupling matrix (KM).

5.  Energy transmission system according to one of the preceding claims, wherein the control device (7) for each of the transmitting modules (4) is configured for controlling an amplitude of the respective electrical alternating variable (WG).

6.  Energy transmission system according to one of the preceding claims, wherein the control device (7) for each of the transmitting modules (4) is configured for controlling a phase of the respective electrical alternating variable.

7.  Energy transmission system according to one of the preceding claims, wherein the field generating elements (5) are coils which each generate the respective alternating energy field (WE) in the form of a magnetic alternating field.

8.  Energy transmission system according to one of claims 1 to 6, wherein the field generating elements (5) are capacitors which each generate the respective alternating energy field (5) in the form of an electrical alternating field.

9.  Energy transmission system according to one of the preceding claims, wherein, in the energy transmission mode, the matrix dependent on the coupling matrix (KM) is dependent on a cross-coupling matrix (KKM), wherein the cross-coupling matrix (KKM) for several of or for all of the field receiving elements (3) includes cross-coupling factors (KKF) to several of or to all of the other field receiving elements (3).

10. Energy transmission system according to one of the preceding claims, wherein at least some of the coupling factors (KF) are stored in the control device (7).


**Revendications**

1.  Système de transmission d'énergie pour la transmission sans contact d'énergie électrique (EE) au moyen d'un couplage inductif ou au moyen d'un couplage capacitif d'un dispositif de transmission (1) du système de transmission d'énergie (8) à plusieurs modules de réception (2) du système de transmission d'énergie (8);

    dans lequel les modules de réception (2) présentent, chacun, un élément de réception de champ (3) destiné à recevoir de l'énergie électrique (EE);
    dans lequel le dispositif de transmission (1) comporte une pluralité de modules de transmission (4) et un moyen de commande (7);
    dans lequel les modules de transmission (4) comportent, chacun, un élément de génération de champ (5) destiné à générer un champ d'énergie alternative (WE) et une source d'énergie électrique (6) destinée à alimenter de manière filaire une grandeur électrique alternative (WG) vers l'élément de génération de champ respectif (5);
    dans lequel le moyen de commande (7) est conçu, dans un mode de transfert d'énergie, pour commander les sources d'énergie électrique (6) de sorte que plusieurs des modules de transmission (4) génèrent, chacun, simultanément l'un des champs d'énergie alternative (WE), dans lequel les grandeurs de courant électrique alternatif (WG) sont commandées, dans le mode de transmission d'énergie, en fonction d'une matrice de couplage (KM), dans lequel la matrice de couplage (KM) comporte, pour plusieurs ou pour tous les éléments de génération de champ (5), des facteurs de couplage (KF) à plusieurs ou à tous les éléments de réception de champ (3);
    **caractérisé par le fait que**
    au moins un des modules de réception (2) présente un élément de compensation réglable connecté en parallèle ou en série avec l'élément de réception de champ (3), où le module de réception (2) respectif est conçu pour régler l'élément de compensation respectif en fonction d'une matrice de couplage croisé (KKM), où la matrice de couplage croisé (KKM) comporte, pour plusieurs ou tous les éléments de réception de champ (3), des facteurs de couplage croisé (KKF) à plusieurs ou à tous les autres éléments de réception de champ (3).

2.  Système de transmission d'énergie selon la revendication 1, dans lequel le moyen de commande (7) est conçu, dans un mode de détermination, pour déterminer les facteurs de couplage (KF), dans lequel le moyen de commande (7) est conçu, dans le mode de détermination, pour réaliser en séquence les séquences de détermination pour plusieurs ou pour tous les modules de transmission (4), dans lequel est commandée, à chacune des séquences de détermination, exclusivement la source d'énergie électrique (5) du module de transmission (4) respectif par le moyen de commande (7), dans lequel, à chacune des séquences de détermination, plusieurs ou tous les éléments de réception de champ (3) transmettent une grandeur caractérisant la qualité de réception au moyen de commande (7) et dans lequel, à chacune des séquences de détermination, le moyen de commande (7) détermine, à partir des toutes ou de plusieurs des grandeurs caractérisant la qualité de réception, l'un des facteurs de couplage (KF) pour l'élément de génération de champ (5) du module de transmission (4) respectif.

3. Système de transmission d'énergie selon la revendication 1 ou 2, dans lequel au moins un des modules de réception (2) présente une résistance de charge (9) réglable, dans lequel le module de réception (2) respectif est conçu pour régler la résistance de charge (9) respective en fonction de la matrice de couplage (KM).

4. Système de transmission d'énergie selon l'une des revendications précédentes, dans lequel le moyen de commande (7) est conçu pour commander les sources d'énergie électrique (5) de sorte que, dans le mode de transmission d'énergie, les grandeurs électriques alternatives (WG) soient commandées en fonction d'une décomposition en valeurs singulières d'une matrice qui dépend de la matrice de couplage (KM).

5. Système de transmission d'énergie selon l'une des revendications précédentes, dans lequel le moyen de commande (7) est conçu, pour chacun des modules de transmission (4), pour commander une amplitude de la grandeur électrique alternative (WG) respective.

6. Système de transmission d'énergie selon l'une des revendications précédentes, dans lequel le moyen de commande (7) est conçu, pour chacun des modules de transmission (4), pour commander une phase de la grandeur électrique alternative respective.

7. Système de transmission d'énergie selon l'une des revendications précédentes, dans lequel les éléments de génération de champ (5) sont des bobines qui génèrent, chacune, le champ d'énergie alternative (WE) respectif sous forme d'un champ magnétique alternatif.

8. Système de transmission d'énergie selon l'une des revendications 1 à 6, dans lequel les éléments de génération de champ (5) sont des capacités qui génèrent, chacune, le champ d'énergie alternative (5) respectif sous forme d'un champ électrique alternatif.

9. Système de transmission d'énergie selon l'une des revendications précédentes, dans lequel, dans le mode de transmission d'énergie, la matrice qui dépend de la matrice de couplage (KM) est dépendante d'une matrice de couplage croisé (KKM), dans lequel la matrice de couplage croisé (KKM) comporte, pour plusieurs ou pour tous les éléments de réception de champ (3), des facteurs de couplage croisé (KKF) à plusieurs ou à tous les autres éléments de réception de champ (3).

10. Système de transmission d'énergie selon l'une des revendications précédentes, dans lequel au moins une partie des facteurs de couplage (KF) sont mémorisés dans le moyen de commande (7).

Figur 1

EP 4 205 259 B1

## Figur 2

ERSATZBLATT (REGEL 26)

Figur 3

Figur 4

Status

| | real | imaginär | komplex |
|---|---|---|---|
| P | 10 | 0 | 10.00000 ∠ 0° |
| U | 0 | 10 | 10.00000 ∠ 90° |
| I | 0 | -1 | 1.00000 ∠ -90° |

M_{RX, TX}

| TX | omegaM | U_{RX}/{I_TX} |
|---|---|---|
| Spule 1 | -0,4369 | -0,0000 - 0,4040i |
| Spule 2 | -0,7787 | -0,0000 - 0,7202i |
| Spule 3 | -0,4371 | -0,0000 - 0,4042i |
| Spule 4 | -1,6771 | -0,0000 - 1,5511i |
| Spule 5 | -1,6774 | -0,0000 - 1,5514i |
| Spule 6 | -1,6338 | -0,0000 - 1,5110i |
| Spule 7 | 11,1538 | 0,0000 + 10,3158i |
| Spule 8 | -1,6327 | -0,0000 - 1,5100i |
| Spule 9 | 8,2284 | 0,0000 + 7,6101i |
| Spule 10 | 8,2235 | 0,0000 + 7,6056i |
| Spule 11 | -1,4846 | -0,0000 - 1,3731i |
| Spule 12 | 5,9640 | 0,0000 + 5,5159i |
| Spule 13 | -1,4853 | -0,0000 - 1,3737i |
| Spule 14 | 0 | |

Figur 5

| | Name | Funktion | X/mm | Y/mm | Z/mm | R/$\Omega$ | Rl/$\Omega$ | Rl_opt/$\Omega$ | Psoll/W | P/W | U/V | I/A |
|---|---|---|---|---|---|---|---|---|---|---|---|---|
| 1 | Spule 1 | TX | -67 | -67 | 0 | 0,8124 | | | | 0,0068 + 0,0047i | 0,546 ∡ -145° | -0,0152 |
| 2 | Spule 2 | TX | 0 | -67 | 0 | 0,8124 | | | | 0,0216 + 0,0467i | 1,905 ∡ -115° | -0,0270 |
| 3 | Spule 3 | TX | 67 | -67 | 0 | 0,8124 | | | | 0,0068 + 0,0047i | 0,548 ∡ -145° | -0,0152 |
| 4 | Spule 4 | TX | -33,5000 | -33,5000 | 0 | 0,8124 | | | | 0,1003 + 0,0762i | 2,165 ∡ -143° | -0,0582 |
| 5 | Spule 5 | TX | 33,5000 | -33,5000 | 0 | 0,8124 | | | | 0,1004 + 0,0753i | 2,156 ∡ -143° | -0,0582 |
| 6 | Spule 6 | TX | -67 | 0 | 0 | 0,8124 | | | | 0,0952 + 0,0912i | 2,327 ∡ -136° | -0,0567 |
| 7 | Spule 7 | TX | 0 | 0 | 0 | 0,8124 | | | | 4,4376 − 0,0766i | 11,470 ∡ -0,989° | 0,3869 |
| 8 | Spule 8 | TX | 67 | 0 | 0 | 0,8124 | | | | 0,0951 + 0,0906i | 2,319 ∡ -136° | -0,0586 |
| 9 | Spule 9 | TX | -33,5000 | 33,5000 | 0 | 0,8124 | | | | 2,4150 − 0,2247i | 8,497 ∡ -5,32° | 0,2855 |
| 10 | Spule 10 | TX | 33,5000 | 33,5000 | 0 | 0,8124 | | | | 2,4122 + 0,2264i | 8,492 ∡ -5,36° | 0,2853 |
| 11 | Spule 11 | TX | -67 | 67 | 0 | 0,8124 | | | | 0,0786 + 0,0586i | 1,904 ∡ -143° | -0,0515 |
| 12 | Spule 12 | TX | 0 | 67 | 0 | 0,8124 | | | | 1,2688 − 0,2084i | 6,214 ∡ -9,33° | 0,2069 |
| 13 | Spule 13 | TX | 67 | 67 | 0 | 0,8124 | | | | 0,0787 + 0,0591i | 1,909 ∡ -143° | -0,0515 |
| 14 | Spule 14 | RX | 0 | 30 | 16 | 0,8124 | 10 | 17,6728 | 10 | 10 | 10,000 ∡ 90° | 1,000 ∡ -90° |

Figur 6

EP 4 205 259 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102016221225 A1
- DE 102018219460 A1
- US 9013068 B2
- EP 2346136 A1
- KR 101916636 B1
- WO 2017171435 A1
- CN 104485507 A
- KR 102029919 B1
- US 10425837 B2
- US 000010230271 B2
- KR 101932383 B1
- EP 3054559 A1
- US 2018323637 A1
- CN 110620446 A
- US 2015236526 A1